(19) Europäisches Patentamt
European Patent Office
Office européen des brevets

(11) Publication number: **0 225 464 A2**

(12) # EUROPEAN PATENT APPLICATION

(21) Application number: 86114968.0

(22) Date of filing: 28.10.86

(51) Int. Cl.⁴: G03F 7/02

(30) Priority: 10.12.85 US 807362

(43) Date of publication of application: 16.06.87 Bulletin 87/25

(84) Designated Contracting States: DE FR GB IT

(71) Applicant: International Business Machines Corporation
Old Orchard Road
Armonk, N.Y. 10504(US)

(72) Inventor: Collini, George John
Box 287, RD 7 Hortontown Road
Hopewell Junction New York 12533(US)
Inventor: Lopata, Alexander Daniel
51 Virginia Avenue
Fishkill New York 12524(US)

(74) Representative: Klein, Daniel Jacques Henri
Compagnie IBM France Département de Propriété Intellectuelle
F-06610 La Gaude(FR)

(54) **Composite resist structures.**

(57) A composite resist structure having a first underlayer of an aqueous alkaline soluble positive photoresist composition and a second, top layer comprised of the reaction product of a novolak type phenol-formaldehyde resin and a 1,2-naphthoquinone-2-diazidio-4-sulfonyl chloride.

EP 0 225 464 A2

Xerox Copy Centre

# COMPOSITE RESIST STRUCTURES

## BACKGROUND OF THE INVENTION

### 1. Field of the Invention

This invention relates generally to resist layer structures and more particularly to composite resist layer structures for use in a lift-off process involved in the fabrication of integrated circuits.

### 2. The Prior Art

One method used for the manufacture of integrated circuits involves the formation of vacuum deposited thin metal films which are etched in the presence of etch resistant photoresist layers to provide the selected pattern. This, in effect, involves the traditional photoengraving or photolithographic etching technique. However, with the continued miniaturization of semiconductor integrated circuits, to achieve greater component density and smaller units in large scale integrated circuitry, the use of such photolithographic etching of deposited film is deficient for providing the minute resolution required for the fine linework of metallization in such large scale integrated circuitry.

An alternative process has been developed by the art to obtain fine minute resolution wherein a bottom layer of underlay of a nonphotosensitive polymeric material is spin-coated on a silicon substrate which may already contain previously patterned layers as well. Then a photoresist composition is spin-coated on the underlay and exposed to a selected pattern of ultraviolet light. Openings are formed in the photoresist layer by development of the ultraviolet light exposed portions of the photoresist layer as well as aligned portions of the polymeric underlay. A thin metal film is then deposited on the undeveloped portions of the photoresist layer and on the substrate through the apertures formed in the photoresist and underlay.

Pattern formation of the deposited thin film layer on the substrate is achieved by subsequent removal of the photoresist/underlay composite together with the excess thin film by immersing the substrate in a solvent which swells or dissolves the polymeric underlay. This alternative method for the formation of patterned metallic films is referred to in the art as the "lift-off" process, and by such process, lateral widths of thin metallic films are deposited on silicon wafer substrates and spaced in the order of 0.5 mils or less.

One drawback to the lift-off technique is that if the second layer of photoresist is directly applied on the underlayer prior to radiation exposure, or after a "soft-bake" (e.g. at about 80°C) of the underlayer, the layers interact and mix with each other at the interface with the result that the imaging photoresist and the underlayer are not of consistent thicknesses and composition across the substrate causing inconsistent and unmanufacturable results.

A lift-off technique which is in conventional use by the art is disclosed in U.S. Patent No. 4,004,044 entitled "Method for Forming Pattern Films Utilizing a Transparent Lift-Off Mask". The method comprises first depositing an organic polymer masking layer such as novolak type phenolformaldehyde resin based resist (e.g. AZ-1350 atop a substrate. After baking (at 210°C) to improve adhesion and thermal stability, a separate glass resin layer (e.g. polydiethylsiloxane) is spin coated over the first masking layer. A second masking layer which may also be a novolak resist is then spin coated on the glass resin layer. The second masking layer is patterned using standard radiation techniques to expose portions of the resin layer in the desired pattern. Using the patterned second masking layer as a mask, openings are dry etched (e.g. reactive ion etching) in the glass resin layer and the first masking layer using two different gases. The second dry etch step is continued until the edges in the openings through the glass resin layer overhang the edges in the openings through the first masking layer thereby forming a lift-off mask. Although the technique disclosed in U.S. Patent 4,004,044 is very effective in providing usable lift-off masks, it is complicated by the need for the glass resin layer and multiple reactive ion etching. A simpler process is therefor desired by the art.

SUMMARY OF THE INVENTION

In accordance with the present invention, there is provided a resist structure for an improved lift-off process, the resist structure having two layers, a first bottom or underlayer comprised of a positive resist composition such as a novolak phenol-formaldehyde resist material sensitized with a diazoquinone compound and a second which is soluble in an aqueous alkaline solution and the second, top layer being comprised of the reaction product of (1) a novolak type phenol-formaldehyde resin represented by the formula

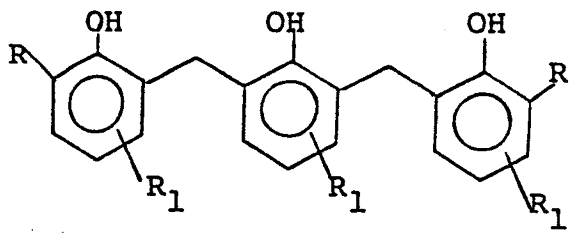

wherein R and $R_1$ are independently selected from a hydrogen atom, an alkyl group containing 1 to 3 carbon atoms, a hologen atom such as chlorine or bromine and an alkoxy group containing 1 to 3 carbon atoms, and (2) a 1,2-naphthoquinone-2-diazidio-4-sulfonyl chloride represented by the formula

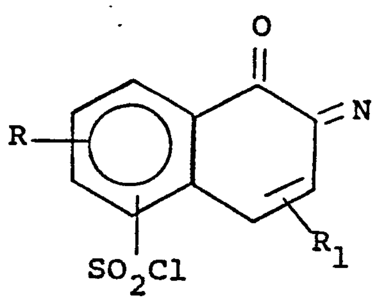

wherein R and $R_1$ are independently selected from hydrogen, an alkyl group containing 1 to 3 carbon atoms, a halogen atom such as chlorine or bromine and an alkoxy group containing 1 to 3 carbon atoms.

Upon image-wise exposure to a source of radiation and development in an alkaline developer, there results a resist profile suitable for lift-off metallization.

The practice of the present invention can also be used for forming a plasma or reactive ion etch mask - (IE) used in the manufacture of integrated circuits. When used as a RIE mask, the metallization step of the lift-off process is not employed, the composite resist functioning as an in-situ mask. Such a mask structure provides a thick, nearly vertical trench in the photoresist, permitting a deep vertical walled trench to be etched into the semiconductor substrate.

DETAILED DESCRIPTION OF THE INVENTION

The photoresist compositions which are applied as the under layer of the composite resist structures of the present invention are generally alkali-soluble positive working photoresist compositions which are castable from organic solvent solutions. Illustrative of such photoresist compositions are alkali-soluble novolak-type phenolformaldehyde resins sensitized with a light sensitive diazoquinone compound. The term "novolak-type phenolformaldehyde resin" as the term is used herein is a resin prepared by the condensation of formaldehyde and phenolic compounds in an acidic medium whereby a novolak resin is formed, i.e. one which has methylene bridges between the phenolic nuclei. Other positive working, aqueous alkaline solution soluble resins include hydroxy containing polystyrene polymers and other polymers used in aqueous base positive working photoresists. Exemplary of diazoquinone compounds which are useful in sensitizing alkaline solution soluble resins, such as the novolak-type phenol-formaldehyde resins, include compounds represented by the formula

$R_1SO_2$ -O-$R_2$

in which $R_1$ is a naphthoquinone-(1,2) diazide radical, $R_2$ is selected from a variety of aliphatic compounds which may also contain halogen or oxygen. illustrative examples of such compounds are disclosed in U.S. Patents 3,046,118, 3,046,121, 3,106,465, 3,201,239 and 3,666,473, the disclosure of which is herein incorporated by reference. A compound preferred for use in the present invention is 2, 3, 4, trihydroxy benzophenone or bis (4,8-hydroxymethyl)-tricyclo [5.2.1.$0^{2,6}$] decane. This last compound when reacted with the napthoquinone-(1,2) diazide radical, will be referred to in the present specification as "BTCDDQ".

In preparing coating solutions of the photoresist material for application as the underlayer of the lift-off composite resist structure of the present invention, the mixture of diazoquinone sensitizer and aqueous alkali soluble resin are dissolved in a suitable organic solvent such as an ester, for example ethyl cellosolve acetate or butyl acetate, at a solids concentration of about 10 to about 40% by weight.

The solids ratio of diazoquinone sensitizer to aqueous alkali-soluble resin dissolved in the solvent is generally in the range of about 1:1 to 1:6 by weight.

The photoresist compositions which form the top layer of the composite resist structures of the present invention are prepared by a condensation reaction between a 1,2-naphthoquinone-2-diazide-4-sulfonyl chloride and a novolak-type cresol formaldehyde resin. The condensation reaction is carried out in an organic solvent such as acetone or pyridine or mixtures thereof. The reaction is preferably carried out by using about 0.8 to about 2.5 equivalents of 1,2-naphthoquinone-2-diazidio-4sulfonyl chloride per 1.0 equivalent of the novolak resin. The reaction temperature is preferably in the range between 40°C and 60°C. The novolak-type cresol formaldehyde resins used to prepare the condensation products used as the top layer composition in the practice of the present invention are low molecular weight compounds having a degree of polymerization of about 1 to 6. novolak resins having a degree of polymerization of about 3 being preferred for use in the preparation of the condensation product.

The novolak-type cresol formaldehyde resins are known to the art and are conveniently prepared by the acid catalyzed e.g. sulfuric acid condensation of para-cresol and 37% formaldehyde in a 3:2 molar concentration. The di-menthol derivative can be readily prepared by based catalyzed addition in methanol.

In preparing the sulfonyl chloride/novolak resin condensation products for use as top layer photoresist materials in the practice of the present invention the sulfonyl salt will condense with the phenolic hydroxyl groups or with a terminal or pendulant methylol groups attached to the aromatic nucleus. It is to be understood that all condensation products of the sulfonyl chloride salt and the novolak-type resin are useful for formulation of the top layer photoresist in accordance with the practice of the present invention.

In preparing formulations for use as photoresist materials for application as the top layer of the lift-off composite resist structures of the present invention, the sulfonyl chloride salt/novolak-type resin condensation product is dissolved in a solvent or mixture of solvents by which the photoresist composition is cast onto the underlayer. In selecting the solvent for the top layer photoresist composition it is critical to the practice of the present invention that the solvent selected by one in which the components of the underlayer photoresist formulation i.e. both solvent and solid components, are substantially immisible during the time required to spincoat and soft bake the top layer photoresist. The sulfonyl chloride/novolak resin condensation product generally comprises about 10 to about 25% by weight of the top layer photoresist formulation, with the remainder being the solvent. Illustrative of solvents useful in the preparation of the top layer photoresist formulations are halogenated organic solvents such as chlorobenzene, dichloromethane, chlorotoluene, low dielectric constant organic solvents such as benzene, toluene and xylene, silyl ethers and dialkyl ethers. Optionally there may also be incorporated in the top layer photoresist formulation a photosensitizer such as BTCDDQ.

The photoresist compositions of the present invention can be supplied to the semiconductor substrate by any conventional method used in the photoresist art, including spraying, dipping, whirling and spin coating. When spin coating, for example, the resist solution can be adjusted as to the percentage of solids content to provide coatings of the desired thickness, given the type of spinning equipment utilized and the amount of time allowed for the spinning process.

To prepare the composite resist structures of the present invention, the under layer photoresist formulation of the diazoquinone sensitized novolak resin is first applied to the semiconductor substrate such as a thermally grown silicon/silicon dioxide coated wafer such as is utilized in the production of microprocessors and other miniaturized integrated circuit components.

After the underlayer resist composition is coated onto the substrate, the substrate is "soft" baked at approximately 60° to 150°C for about 1 to about 30 minutes for partial removal of the solvent whereby a thin underlayer of photoresist composition in the order of 1 to 4 microns in thickness remains on the substrate.

A photoresist composition commercially available from the Shipley Corporation and sold under the trademark designed AZ-1350 is preferred for use as the underlayer photoresist composition in the preparation of the lift-off composite resist structures of the present invention. AZ-1350 comprises a novolak-type phenolformaldehyde resin and a diazoquinone photosensitive compound believed to be 4′, 2′, 3′-dihydroxybenzophenone mixed esters of 1-oxo-2-diazo-naphthalene-5-sulfonic acid, the mixture of diazoquinone sensitizer and novolak resin being dissolved in a mixture of ethyl cellosolve acetate, n-bytyl acetate and xylene.

After the soft baking of the novolak coating, a layer of the sulfonyl chloride salt/novolak resin condensation product is deposited on the soft baked novolak resin underlayer. After the top layer resist composition is coated onto the substrate, the substrate is baked at approximately 75 to 150°C for about 1 to 40 minutes until all the solvent has evaporated and only a thin top layer of photoresist composition on the order of 0.1 to 1.0 micron in thickness remains on the novolak resin underlayer.

Application of the top layer to the soft baked novolak resin layer occurs without significant mixing of the layers. However, and sensitizer present in the top layer resist composition will diffuse into the under layer at the interface of the two layers. This diffusion reduces the solubility to alkaline solutions of the surfaces of the underlayer which interface the top layer.

After baking, the composite resist structure is exposed to radiation which will cause the sensitizers in the layers to react. Conventionally actinic light is used, but various forms of high energy radiation such as x-ray and electron beam may be employed. The photoresist compositions used in the practice of the present invention are particularly suitable to exposure to actinic radiation in the mid ultraviolet range (300-350 nanometers) and the near ultraviolet range (365 to 450 nanometers).

The exposure of the photoresist takes place either through a pattern mask or by directing a shaped beam of radiation across the surface of the photosensitive layers.

A relief image is developed in the composite resist structure by treating the composite structure with an alkaline solution such as either an aqueous solution of a mixture of sodium metal silicate, sodium phosphate and sodium ortho phosphate or dilute sodium hydroxide, which solutions preferentially remove the exposed solubilized portions of the resist layers.

During development of the photoresist with the alkaline developer, the underlayer tends to etch faster in the developer solution due to the greater solubility of the underlayer photoresist composition as compared to the top layer photoresist composition. The greater solubility of the underlayer photoresist is due to the fact that the novolak-type phenol formaldehyde resin is more soluble in alkaline solutions as compared to the sulfonyl chloride salt/novolak resin condensation product. Also diffusion of sensitizer form the top layer to the bottom layer photoresist enriches the sensitizer concentration in the bottom layer whereby the exposed top layer photoresist is rendered comparatively less soluble in the developer solution and the under layer portion receiving the diffused quantity of sensitizer is rendered more soluble upon radiation exposure. The result of this reduced solubility in the top layer of the composite photoresist structure is that radiation exposure defines a highly controllable dissolvable width in the top layer, while in the underlayer, both the exposing radiation and the original compositional differences between the layers, results in a comparatively higher solubility of the underlayer resist whereby a gradient of increasing solubility is created through the pattern exposed resist layers. Upon development of the resist layers, the rate of solubility increases with depth so that lateral development proceeds more quickly nearer the substrate to give a steeper or an undercut relief profile. When the patterned resist layer is processed by metal deposition followed by removal of the resist and overlying metal to leave a patterned layer of metal adhered to the substrate (lift-off process) excellent results are obtained. This is believed due to a resist edge profile which is very steep or even undercut. The undercut profile aids in forming a discontinuity between the portions of the deposited metal which are on the substrate surface and the portions which cover the resist which promotes easy lift-off of the resist film. Bridging of the metal between the portion on the substrate and the portion covering the resist would otherwise impede lift-off of the resist film.

Thus after the development of the resist structure and the formation of an aperture pattern therein, a thin metallic film is deposited, as by vacuum deposition, on the photoresist layers and the substrate through the apertures etched in the composite resist structure. The metal may be any metal conventionally used for integrated circuit metallization, that is, aluminum-copper alloys, copper, chromium, silver, tantalum, gold and combination thereof. The thin metallic films generally have a thickness in the order of 0.5 microns.

After deposition of the thin metallic film, the underlay of the present invention can be readily and rapidly removed by conventional lift-off techniques as by immersion in a solvent which dissolves or swells the novolac-type phenol formaldehyde resin layer without affecting the thin metallic film. Suitable solvents include acetone, butyl acetate, trichloroethylene and cellosolve acetate. A preferred lift-off technique is to immerse the substrate in a solvent such as N-methyl-2-pyrrolidinone for about 5 to 10 minutes with or without ultrasonic agitation. Removal of the deposited layers leaves a thin metal film in the desired preselected configuration on the substrate.

The present invention is illustrated by the following example:

EXAMPLE

An underlay film for use in a lift-off process was deposited by spin coating a 2.3 µm thick layer of AZ-1350J photosensitized novolak resin on a $SiO_2$ and then soft baking for 10 minutes at 85°C.

A formulation to prepare a top layer film for the structure was prepared by dissolving in 5 grams of chlorobenzene 1 gram of the condensation product by reacting 1 equivalent of a novolak-type cresol-formaldehyde resin having a degree of polymerization about 3 and 2 equivalents of 1,2-naphthoquinone-2-diazidio-4sulfonyl chloride. Also incorporated in the chlorobenzene solvent was 0.25 gram of the sensitizer BTCDDQ.

The top layer formulation was spincoated on the soft baked novolak resin underlayer and the deposited film was baked at 85°C for 10 minutes to prepare a 1.0 micron thick film of the condensation product. The wafer was then exposed in ultraviolet light in an exposure apparatus having an intensity of about 200-400 mj/cm$^2$ at a wavelength of 313 nanometers through a metal mask having a pattern of 2.25 micron wide bars having 2.75 micron separations.

The exposed wafer was then immersed for 120 seconds at 23°C in an alkaline developer solution composed of AZ 2401 which is 1.14N KOH in water containing a surfactant diluted by volume in the ratio of 1:3.0 with deionized water. The relief image formed had line widths in the order of 1.5 µm. The developed layers were then vacuum metallized with an Al/Cu alloy. Lift-off was accomplished by immersing the metallized wafer in a 1:1 volume ratio of toluene/acetone at 23°C. The metal coating was lifted off from the wafer substrate within 15 minutes.

The substrates were examined under a microscope and found to be free of unlifted metal. Photomicrographs taken at 10.000 x magnification indicated that the metal lines had good resolution and fidelity to mask dimensions.

While specific components of the present system are defined above, many other variables may be introduced which may in any way affect, enhance, or otherwise improve the system of the present invention. These are intended to be included herein.

Although variations are shown in the present application, many modifications and ramifications will occur to those skilled in the art upon a reading of the present disclosure. These, too, are intended to be included herein.

**Claims**

1. A composite resist structure for the manufacture of integrated circuits, the resist structure being comprised of (a) a first underlayer of an aqueous alkaline soluble positive photoresist composition and (b) a second, top layer composition comprised of the reaction product of (1) a novolak type cresol-formaldehyde resin represented by the formula

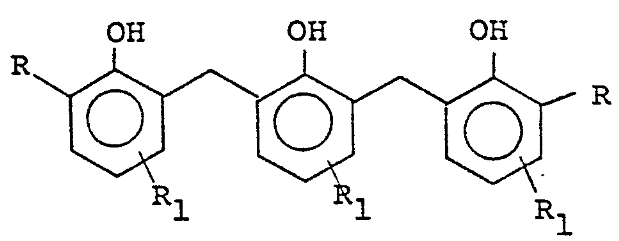

wherein R and $R_1$ are independently selected from hydrogen, an alkyl group containing 1 to 3 carbon

atoms, a halogen atom and an alkoxy group containing 1 to 3 carbon atoms, and (2) 1,2-naphthoquinone-2-diazidio-4 sulfonyl chloride represented by the formula

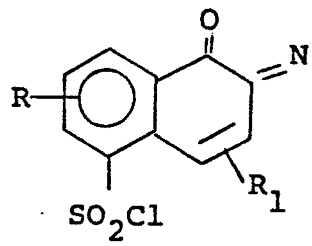

wherein R and $R_1$ are independently selected from hydrogen, an alkyl group containing 1 to 3 carbon atoms, a halogen atom and an alkoxy group containing 1 to 3 carbon atoms.

2. The composite resist structure of Claim 1 wherein the first underlayer composition is comprised of a novolak-type phenol formaldehyde resin sensitized with a diazoquinone compound.

3. The composite resist structure of Claim 1 wherein a sensitizer is incorporated in the top layer composition.

4. The composite resist structure of Claim 3 wherein the sensitizer is the reaction product of bis (4,8-hydrosymethyl)-tricyclo [5.2.1.0.$^{2,6}$] decane and a 1,2-naphthoquinone-2-diazidio-4sulfonyl chloride represented by the formula

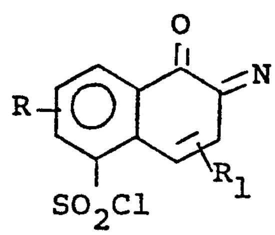

wherein R and $R_1$ are independently selected from hydrogen, and alkyl group containing 1 to 3 carbon atoms, a halogen atom, and a alkoxy group containing 1 to 3 carbon atoms.

5. The composite resist structure of Claim 1 wherein the top layer is comprised of a mixture of about 75 to about 90 percent by weight of the reaction product of 1,2-naphthoquinone-2-diazidio-4-sulfonyl chloride and a novolak-type cresol-formaldehyde resin represented by the formula

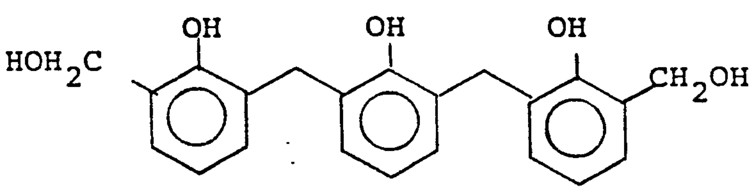

and about 10 to about 25 percent by weight of a sensitizer.

6. The composite structure of Claim 5 wherein the reaction product is the reaction product of about 0.8 to about 2.5 equivalents of 1,2-naphthoquinone-2-diazidio-4-sulfonyl chloride per 1 equivalent of the novolak resin.

7. A process for the preparation of a composite resist structure for use in a lift-off process which comprises coating a substrate sequentially with a first layer comprised of an aqueous alkaline soluble positive photoresist composition, overcoating the first layer with a second layer comprised of the reaction product of (1) a novolak type cresol-formaldehyde resin represented by the formula

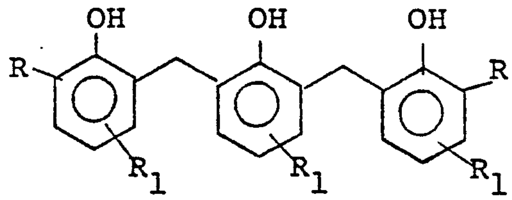

wherein R and R, are independently selected from a hydrogen atom, an alkyl group containing 1 to 3 carbon atoms, a halogen atom and an alkoxy group containing 1 to 3 carbon atoms, and (2) 1,2-naphthoquinone-2-diazidio-4-sulfonyl chloride represented by the formula

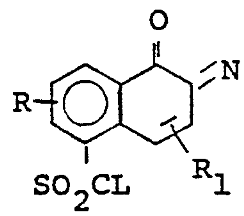

wherein R and R, are independently selected from hydrogen, an alkyl group containing 1 to 3 carbon atoms a halogen atom and an alkoxy group containing 1 to 3 carbon atoms, the second layer having a solubility in alkaline media which is less than that of the first layer, patternwise exposing the layers with a source of radiation and then developing the layers in an alkaline medium.

8. The process of Claim 7 wherein the first layer is comprised of a novolak-type phenol-formaldehyde resin and a diazoquinone sensitizer.

9. The process of Claim 7 wherein a sensitizer is incorporated in the top layer composition.

10. The process of Claim 9 wherein the sensitizer is the reaction product of bis (4,8-hydroxymethyl)-tricyclo [5.2.1.0.$^{2,6}$ ] decane and a 1,2-naphthoquinone-2-diazidio-4-sulfonyl chloride represented by the formula

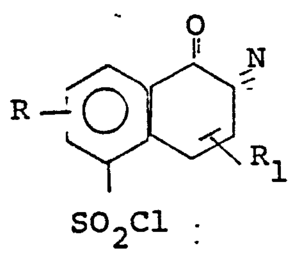

wherein R and R, are independently selected from hydrogen, an alkyl group containing 1 to 3 carbon atoms, a halogen atom, and an alkoxy group containing 1 to 3 carbon atoms.

11. The process of Claim 7 wherein the second layer reaction product is the reaction product of 1,2-naphthoquinone-2-diazidio-4-sulfonyl chloride and a novolak phenol-formaldehyde resin represented by the formula

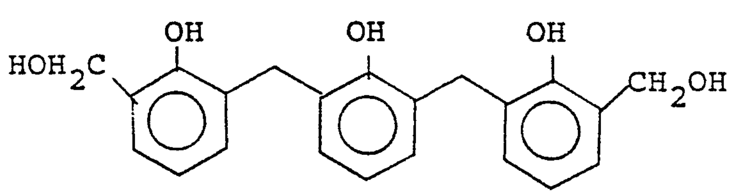

12. The process of Claim 11 wherein the reaction product is the reaction product about 0.8 to about 2.5 equivalents of 1,2-naphthoquinone-2-diazidio-4-sulfonyl chloride per 1 equivalent of the novolak resin.

13. The process of Claim 7 wherein the substrate is softbaked at about 60° to about 150°C for about 1 to 30 minutes before the deposit of the second layer thereon.

14. The process of Claim 7 wherein the substrate is baked at about 75° to about 150°C for about 1 to about 40 minutes after application of the second layer and before image-wise exposure.

15. The process of Claim 6 wherein the exposed layers are developed in a solution whose major component is alkaline water.

16. The process of Claim 5 wherein the first layer has a thickness of about 1.0 to about 4.0 µm and the second layer has a thickness of about 0.1 to about 1.0 µm.